# EUROPEAN PATENT APPLICATION

(11) **EP 2 824 712 A1**
(43) Date of publication of application: **14.01.2015**
(21) Application number: 13192492.0
(22) Date of filing: 12.11.2013
(51) Int. Cl.: H01L 31/0224, H01L 31/05

(54) **Back contact solar cell**

(30) Priority: 09.07.2013 TW 102124553
(71) Applicant: Inventec Solar Energy Corporation, Taoyuan County 33547 (TW)
(72) Inventor: Lin, Chia-Lung, 220 New Taipei City (TW); Cheng, Yu-Ta, 330 Taoyuan County (TW); Chen, Chuan-Chi, Nangang Dist., Taipei City (TW); Chien, Jung-Wu, Hsin-chu County (TW)
(74) Representative: Reichert & Lindner Partnerschaft Patentanwälte

(57) **Abstract**

A back contact solar cell includes a first main busbar electrode, a second main busbar electrode, a plurality of first finger electrodes and a plurality of second finger electrodes, all of which are disposed on a back surface of the back contact solar cell and extending along a first direction. The back contact solar cell further includes a first sub-busbar electrode and a second sub-busbar electrode, which are extending along a second direction. The first finger electrodes are electrically connected to an N-type doped region, and the second finger electrodes are electrically connected to a P-type doped region. The first sub-busbar electrode is electrically connected to the first main busbar electrode and the first finger electrodes. The second sub-busbar electrode is electrically connected to the second main busbar electrode and the second finger electrodes.

## Description

### FIELD OF THE INVENTION

The present invention relates to a structure of a solar cell, and more particularly to an electrode configuration of a back contact solar cell.

### BACKGROUND OF THE INVENTION

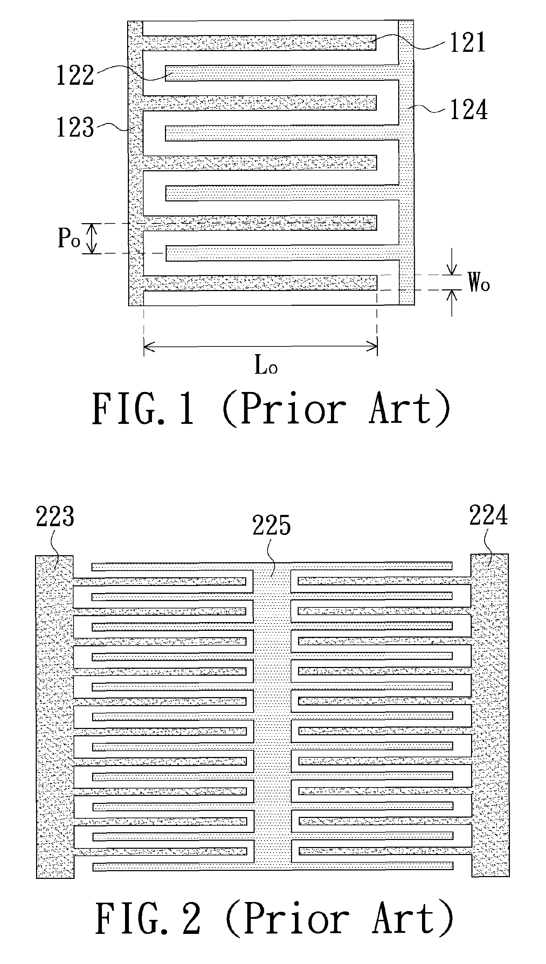

In a conventional solar cell, top electrodes are disposed on an upper surface of a substrate, and bottom electrodes are disposed on a lower surface of the substrate. The upper surface is configured for receiving sunlight, but the top electrodes disposed on the upper surface will block incident sunlight and a photoelectric conversion efficiency of the solar cell will be adversely affected. In order to solve the problem, a back contact solar cell is developed wherein both the top electrodes and the bottom electrodes (or said positive electrodes and negative electrodes) are arranged on a back surface opposite to the light receiving surface of the substrate in an interdigitated mode. FIG. 1 is a schematic plan view illustrating a back surface of the conventional back contact solar cell. This back contact solar cell includes a positive busbar electrode 123, a plurality of positive finger electrodes 121, a negative busbar electrode 124, and a plurality of negative finger electrodes 122. The positive busbar electrode 123 connecting the positive finger electrodes 121 and the negative busbar electrode 124 connecting the negative finger electrodes 122 are disposed at opposite ends of the back surface, and the positive finger electrodes 121 and the negative finger electrodes 122 are arranged alternately.

However, when a size of the substrate becomes larger, a length L₀ of the finger electrodes 121, 122 becomes relatively longer, which increases loading current of the finger electrodes 121, 122, and the resistance thereof keeps higher. To reduce output lost of the solar cell, the resistance of the finger electrodes 121, 122 should be lowered. To lower the resistance of the finger electrodes 121, 122, a method is to increase their cross-sectional area which may be achieved by increasing width W₀ or thickness (height) of the finger electrodes 121, 122. However, it is known that increasing the thickness of the finger electrodes 121, 122 does not comply with the compact volume trend. If the width W₀ of the finger electrodes 121, 122 increases, the pitch P₀ between the neighboring finger electrodes 121 and 122 becomes larger, which causes a longer moving distance for the carriers (electrons or holes) in the silicon substrate. It leads to the problem of reduction in the photoelectric conversion efficiency and output of the solar cell. Moreover, the wider finger electrodes will cause wafer bowing and electrode peeling due to high stress.

In order to solve the above-mentioned problems, a back contact solar cell having three busbar electrodes is proposed, as shown in FIG. 2. In addition to the busbar electrodes 223, 224 located at opposite ends of the back surface, a busbar electrode 225 crossing the finger electrodes is inserted at the middle area of the back surface. Thus, the length of the finger electrodes may be shortened and the loading current of each finger electrode is reduced. The polarity of the busbar electrode 225 is different from that of the busbar electrodes 223, 224. For example, the busbar electrode 225 disposed at the middle area is configured for collecting positive currents, and the busbar electrodes 223, 224 disposed at opposite ends are configured for collecting negative currents. There is only one busbar electrode 225 for collecting the positive currents, while there are two busbar electrodes 223, 224 for collecting the negative currents. The loading current density of the busbar electrode 225 is larger than that of the busbar electrodes 223, 224. That will adversely affect the photoelectric conversion efficiency of the solar cell.

In view of the aforementioned reasons, there is a need to modify the back contact solar cell to reduce the resistance of the finger electrodes. Furthermore, the wafer bowing and electrode peeling issues can be solved without cell output sacrifice to improve the characteristics of the back contact solar cell.

### SUMMARY OF THE INVENTION

The present invention provides a back contact solar cell having shorter finger electrodes to enhance the photoelectric conversion efficiency of the back contact solar cell.

In accordance with an aspect of the present invention, a back contact solar cell is provided. The back contact solar cell includes a main body, a first main busbar electrode, a second main busbar electrode, a first sub-busbar electrode, a second sub-busbar electrode, a plurality of first finger electrodes and a plurality of second finger electrodes. The main body includes at least one N-type doped region and at least one P-type doped region, and has a light receiving surface and a back surface opposite to the light receiving surface. The first main busbar electrode, the second main busbar electrode, the first finger electrodes and the second finger electrodes are disposed on the back surface and extending along a first direction. The first finger electrodes are electrically connected to the N-type doped region, and the second finger electrodes are electrically connected to the P-type doped regions. The first finger electrodes and the second finger electrodes are parallel and arranged alternately. The first sub-busbar electrode and the second sub-busbar electrode are disposed on the back surface and extending along a second direction different from the first direction. The first sub-busbar electrode is electrically connected to the first main busbar electrode and the first finger electrodes, while the second sub-busbar electrode is electrically connected to the second main busbar electrode and the second finger electrodes.

In accordance with another aspect of the present invention, a solar cell string including the back contact solar cells is provided. The back contact solar cells are connected in series. The second main busbar electrode of one back contact solar cell is electrically connected to the first main busbar electrode of a previous back contact solar cell, and the first main busbar electrode of the one back contact solar cell is electrically connected to the second main busbar electrode of a next back contact solar cell.

For making the above and other purposes, features and benefits become more readily apparent to those ordinarily skilled in the art, the preferred embodiments and the detailed descriptions with accompanying drawings will be put forward in the following descriptions.

### BRIEF DESCRIPTION OF THE DRAWINGS

The present invention will become more readily apparent to those ordinarily skilled in the art after reviewing the following detailed description and accompanying drawings, in which:
FIG. 1 is a schematic plan view illustrating a back surface of a conventional back contact solar cell;
FIG. 2 is a schematic plan view illustrating a back surface of another conventional back contact solar cell having three busbar electrodes;
FIG. 3A is a schematic plan view illustrating a back surface of a back contact solar cell in accordance with an embodiment of the present invention;
FIGS. 3B∼3C are schematic cross-sectional views taken along line a-a' in FIG. 3A;
FIG. 4A is a schematic plan view illustrating a back surface of a back contact solar cell in accordance with another embodiment of the present invention;
FIG. 4B is a schematic cross-sectional view taken along line b-b' in FIG. 4A;
FIG. 5 is a schematic perspective view illustrating a part of a back contact solar cell in accordance with a further embodiment of the present invention;
FIG. 6 is a schematic perspective view illustrating a part of a back contact solar cell in accordance with a further embodiment of the present invention; and
FIG. 7 is a schematic plan view illustrating a solar cell string having a plurality of back contact solar cells of FIG. 4A.

### DETAILED DESCRIPTION OF PREFERRED EMBODIMENTS

The present invention will now be described more specifically with reference to the following embodiments. It is to be noted that the following descriptions of preferred embodiments of this invention are presented herein for purpose of illustration and description only. It is not intended to be exhaustive or to be limited to the precise form disclosed.

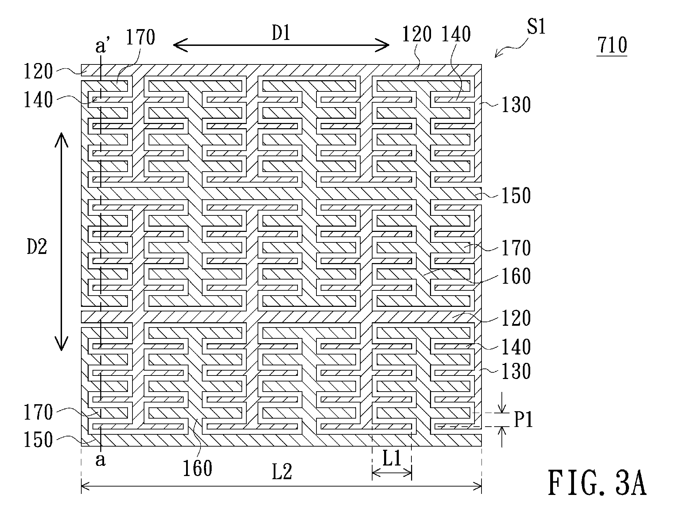

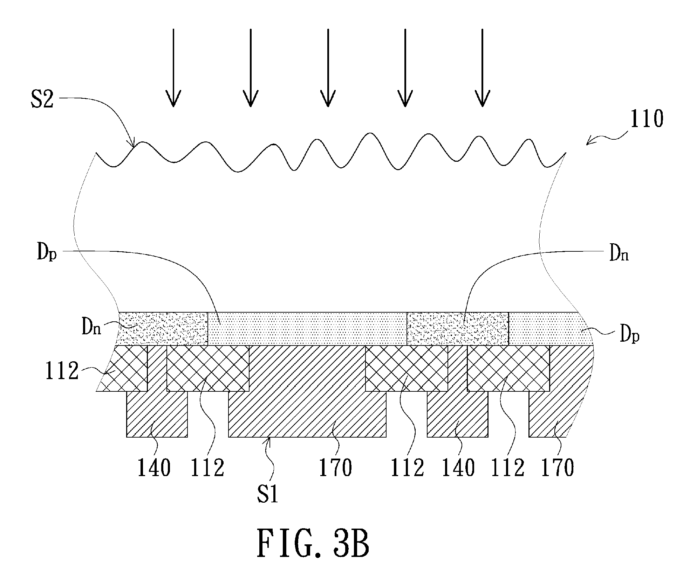

FIG. 3A is a schematic plan view illustrating a back surface of a back contact solar cell in accordance with an embodiment of the present invention. FIGS.3B∼3C are schematic cross-sectional views taken along line a-a' in FIG. 3A. The back contact solar cell 710 includes a main body 110, at least one first main busbar electrode 120, at least one first sub-busbar electrode 130, a plurality of first finger electrodes 140, at least one second main busbar electrode 150, at least one second sub-busbar electrode 160 and a plurality of second finger electrodes 170.

Please be noted that the number, size, scale or dimension of each element shown in the drawings are only for illustrative purpose, but the structure can be modified to meet any requirement. For example, the number of the finger electrodes connected to a sub-busbar electrode in the drawing is less than the real design in order to best explain the principles of the present invention.

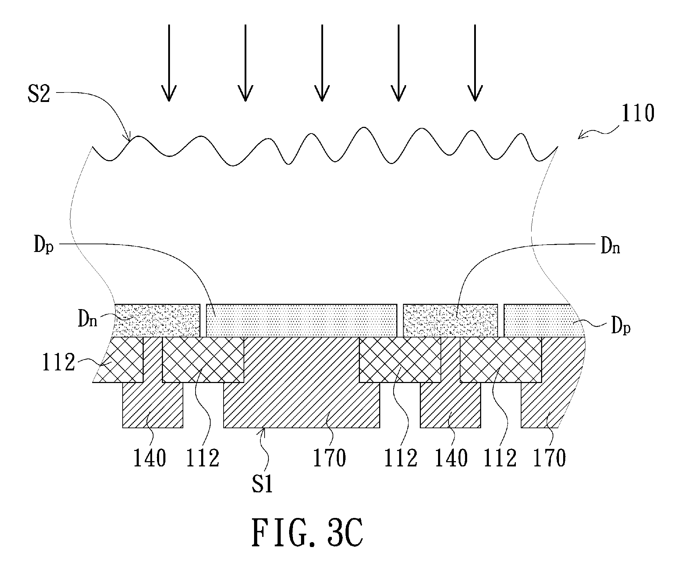

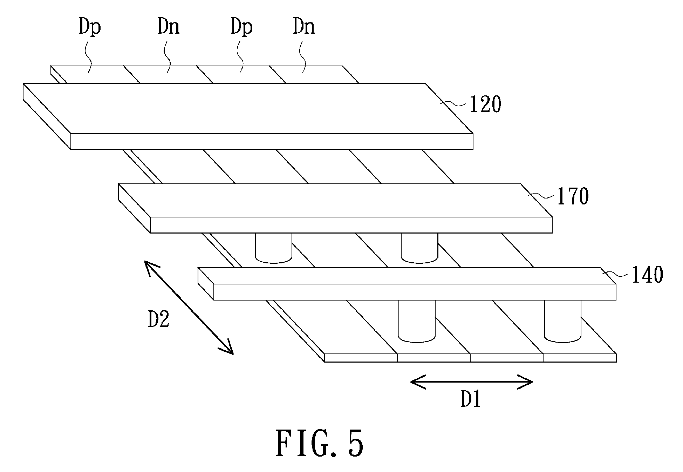

Please refer to FIGS. 3B∼3C illustrating the cross-sectional views of the back contact solar cell 710. The main body 110 includes a back surface S1, a light receiving surface S2, a plurality of strip-shaped N-type doped regions Dn, a plurality of strip-shaped P-type doped regions Dp and a dielectric layer 112. The light receiving surface S2 configured to receive the sunlight is a rough surface to enhance a light absorption efficiency of the light receiving surface S2. The N-type doped regions Dn and the P-type doped regions Dp are parallel and arranged alternately. The N-type doped regions Dn may be connected to (in direct contact with) the P-type doped regions Dp (FIG. 3B) or may be separated from the P-type doped regions Dp by the main body 110 (FIG. 3C). In these embodiments, although the N-type doped regions Dn and the P-type doped regions Dp are disposed in the main body 110 and near the back surface S1, it is to be noted that the present invention does not limit the positions of the N-type doped regions Dn and the P-type doped regions Dp disposed in the main body 110. In an embodiment, the N-type doped regions Dn and the P-type doped regions Dp extend along a first direction D1, and so do the first finger electrodes 140 and the second finger electrodes 170. Accordingly, each of the first finger electrodes 140 is electrically connected to a corresponding N-type doped region Dn, while each of the second finger electrodes 170 is electrically connected to a corresponding P-type doped region Dp, as shown in FIG. 3B and FIG. 3C. In another embodiment, the N-type doped regions Dn and the P-type doped regions Dp extend along a direction perpendicular to or other than the first direction D1, which will be described with reference to FIG. 5 later. Moreover, the first finger electrodes 140 are isolated from the second finger electrodes 170 by the dielectric layer 112. In an embodiment, a width of the second finger electrode 170 is greater than or equal to a width of the first finger electrode 140.

Please refer back to FIG. 3A and FIG. 3B. The first main busbar electrode 120, the second main busbar electrode 150, the first finger electrodes 140 and the second finger electrodes 170 are formed on the back surface S1 and extending along the first direction D1. Relative to the first main busbar electrode 120, the second main busbar electrode 150 is disposed at the other side of the finger electrodes 140 and 170. The first finger electrodes 140 and the second finger electrodes 170 are parallel and arranged alternately. The first sub-busbar electrode 130 and the second sub-busbar electrode 160 are disposed on the back surface S1 and extending along a second direction D2, wherein the angle between the first direction D1 and the second direction D2 may range from 45 degrees to 90 degrees. In particular, the first sub-busbar electrode 130 is electrically connected between the first main busbar electrode 120 and the first finger electrodes 140, while the second sub-busbar electrode 160 is electrically connected between the second main busbar electrode 150 and the second finger electrodes 170. The shape of the combination of the first sub-busbar electrode 130 and the linked first finger electrodes 140 is like a comb or a fishbone. The similar shape is also applied to the combination of the second sub-busbar electrode 160 and the linked second finger electrodes 170. The first sub-busbar electrode 130 has a width less than the width of the first main busbar electrode 120 and greater than the width of the first finger electrodes 140, while the second sub-busbar electrode 160 has a width less than the width of the second main busbar electrode 150 and greater than the width of the second finger electrodes 170 (not precisely shown in the schematic view of FIG. 3A). For example, the width of the first main busbar electrode 120, the first sub-busbar electrode 130 and the first finger electrode 140 is 2 mm, 0.4 mm and 80 µm, respectively.

In the present invention, the sub-busbar electrodes 130 and 160 respectively collect current from the finger electrodes 140 and 170, and then respectively deliver the collected current to the main busbar electrodes 120 and 150. By ways of introducing the sub-busbar electrodes 130 and 160, the length L1 of the finger electrodes 140 and 170 are shortened. In FIG. 3A, four first sub-busbar electrodes 130 and four second sub-busbar electrodes 160 are provided, but the number may be modified according to different applications. Thus, the length L1 of the finger electrodes 140, 170 can be shortened to about 1/7 of the cell length L2. Therefore, the loading current density of the finger electrodes 140, 170 and the resistance are reduced without increasing the width or thickness of the finger electrodes 140, 170 because of short length of the finger electrodes 140, 170. Moreover, the pitch PI between the neighboring finger electrodes 140 and 170 keeps small or even smaller, contributing to a short moving distance for the carriers (electrons or holes) in the silicon substrate to enhance the photoelectric conversion efficiency of the back contact solar cell 710. Furthermore, compared to the prior arts, the use of the thinner finger electrodes 140, 170 can effectively prevent the wafer bowing and electrode peeling issues to increase production capacity and yield. In FIG. 3A, two first main busbar electrodes 120, two second main busbar electrodes 150, four first sub-busbar electrodes 130, and four second sub-busbar electrodes 160 are shown in one solar cell 710, but the number should not be limited and narrow the invention scope. Similarly, the number of the finger electrodes 140, 170 may vary with different designs.

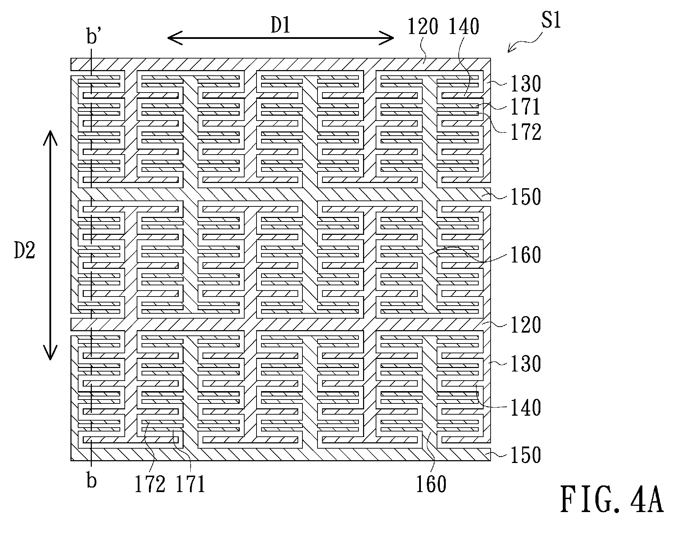

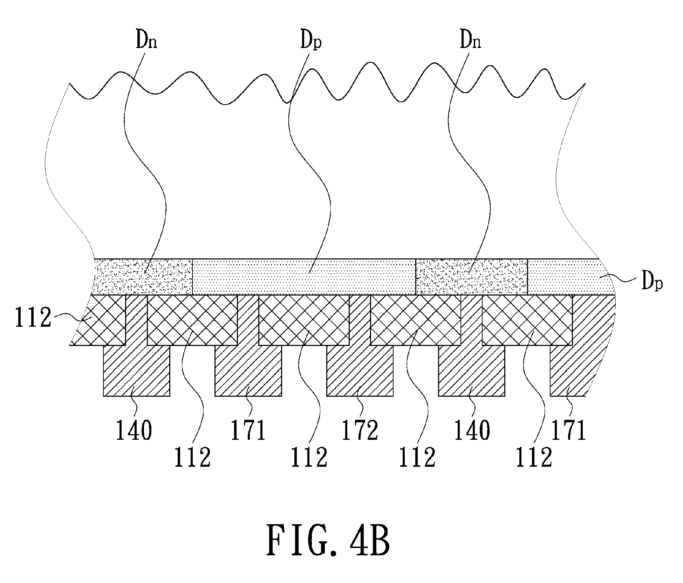

FIG. 4A is a schematic plan view illustrating a back surface of a back contact solar cell in accordance with another embodiment of the present invention. FIG. 4B is a schematic cross-sectional view taken along line b-b' in FIG. 4A. In FIG. 4B, the N-type doped regions Dn and the P-type doped regions Dp extend along the first direction D1. The structure shown in FIG. 4A and FIG. 4B is similar to that described with reference to FIG. 3A and FIG. 3B. One exception is that, between every two neighboring first finger electrodes 140, each second finger electrode has two branches 171 and 172 electrically connected to the same P-type doped region Dp (see FIG. 4B). The width of the branches 171, 172 of the second finger electrode is less than or equal to that of the first finger electrode 140.

When the solar cell receives the sunlight, the electrons and the holes in specific regions of the substrate or main body are excited. The holes flow through the branches 171, 172 of the second finger electrodes to the second sub-busbar electrode 160, and then the holes are collected at the second main busbar electrode 150. The electrodes 150, 160, 170 are collectively called as positive electrodes. In a similar way, the electrons flow through the first finger electrodes 140 to the first sub-busbar electrode 130, and then the electrons are collected at the first main busbar electrode 120. The electrodes 120, 130, 140 are collectively called negative electrodes. Compared to the second finger electrode 170 in the above-described embodiment with reference to FIG. 3B, the moving distance for the holes is shorter. Since hole mobility is less than electron mobility, the shorter moving distance to the branches 171, 172 of the second finger electrodes for the holes can enhance the photoelectric conversion efficiency of the back contact solar cell 710. Furthermore, another advantage of the thinner second finger electrodes 171, 172 is to reduce the formation stress on the substrate of main body, thereby improving the electrode peeling problem. It is to be noted that the N-type doped regions Dn may be connected to or separated from the P-type doped regions Dp, as exemplified previously.

FIG. 5 is a schematic perspective view illustrating a part of a back contact solar cell in accordance with an embodiment of the present invention. The N-type doped regions Dn and the P-type doped regions Dp extend along a second direction D2 perpendicular to or other than the first direction D1, i.e. the lengthwise direction of the first finger electrodes 140 and the second finger electrodes 170. The N-type doped regions Dn and the P-type doped regions Dp are parallel and arranged alternately along the first direction D1. Thus, each of the first finger electrodes 140 is, for example, electrically connected to the N-type doped regions Dn by point contact; and each of the second finger electrodes 170 is, for example, electrically connected to the P-type doped regions by point contact.

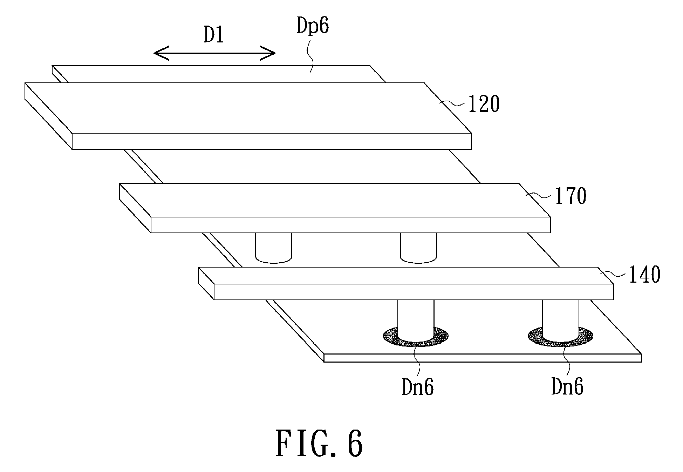

FIG. 6 is a schematic perspective view illustrating a part of a back contact solar cell in accordance with another embodiment of the present invention. The P-type doped region Dp6 is implemented by a continuous layer, but not a strip-shaped layer such as the P-type doped region Dp shown in FIG. 5. The N-type doped region Dn6 may be a discontinuous layer and surrounded by the P-type doped region Dp6, but not a strip-shaped layer such as the N-type doped region Dn shown in FIG. 5. Moreover, the shape of the N-type doped region Dn6 may be circular, quadrangular or polygonal (not shown) according to the doping pattern. Each of the first finger electrodes 140 is, for example, electrically connected to the N-type doped regions Dn6 by point contact; and each of the second finger electrodes 170 is, for example, electrically connected to the single P-type doped region Dp6 by point contact.

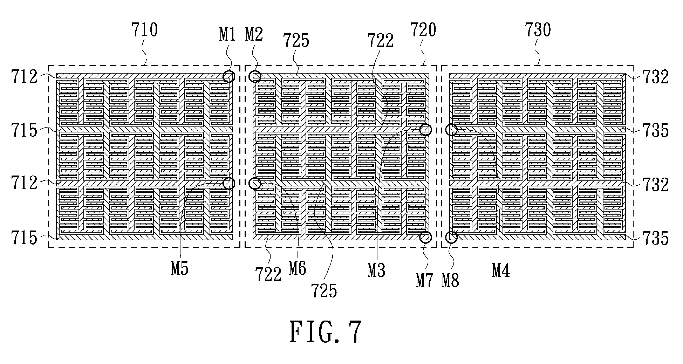

FIG. 7 is a schematic plan view illustrating a solar cell string having a plurality of back contact solar cells of FIG. 4A. The solar cell string includes three solar cells 710, 720 and 730, and they have the same electrode arrangement. In the solar cell string, the second solar cell 720 is disposed between the first solar cell 710 and the third solar cell 730. The second main busbar electrode 725 of the second solar cell 720 is electrically connected to the first main busbar electrode 712 of the first solar cell 710. On the other hand, the first main busbar electrode 722 of the second solar cell 720 is electrically connected to the second main busbar electrode 735 of the third solar cell 730. In more detail, ends M2, M6 of the second main busbar electrodes 725 of the second solar cell 720 are electrically connected to ends M1, M5 of the first main busbar electrodes 712 of the first solar cell 710, respectively. On the other hand, ends M3, M7 of the first main busbar electrodes 722 of the second solar cell 720 are electrically connected to ends M4, M8 of the second main busbar electrodes 735 of the third solar cell 730, respectively. It is to be noted that in the solar cell string, the second solar cell 720 is rotated 180 degrees around an axis (not shown) perpendicular to the surface of the substrate or main body while the first solar cell 710 and the third solar cell 730 remain their orientation. After the rotation, the shape of the second main busbar electrode 725 (together with the second sub-busbar electrodes) of the second solar cell 720 is identical to the shape of the first main busbar electrode 712, 732 (together with the first sub-busbar electrodes) of the first solar cell 710 and the third solar cell 730. Similarly, after the rotation, the shape of the first main busbar electrode 722 (together with the first sub-busbar electrodes) of the second solar cell 720 is identical to the shape of the second main busbar electrode 715 and 735 (together with the second sub-busbar electrodes) of the first solar cell 710 and the third solar cell 730. In other words, in a solar cell, the first main busbar electrode combined with the first sub-busbar electrodes is a rotational symmetry of the second main busbar electrode combined with the second sub-busbar electrodes. Therefore, the solar cells can be easily connected with each other by wire bonding or ribbon bonding to form the solar cell string or a solar cell module without different designs for two halves of the solar cells. Certainly, other solar cells with modified quantity of the main busbar electrodes, the sub-busbar electrodes and the finger electrodes derived from the embodiments and description of the present invention may be utilized to provide the solar cell string or solar cell module in a similar way, and redundant details are not given herein. The number of the solar cells in one solar cell string is also unlimited.

In summary, according to the present invention, the principle is to use the sub-busbar electrodes to collect (positive or negative) current from the finger electrodes, and then deliver the collected current to the main busbar electrodes. By utilizing the sub-busbar electrodes thinner than the main busbar electrodes, the length of the finger electrodes can be shortened and the loading current density of the finger electrodes are reduced, thereby reducing a series resistance and maximizing a fill factor and the photoelectric conversion efficiency of the solar cell. Furthermore, when the loading current density of the finger electrodes become smaller, the width and the thickness of the finger electrodes may be reduced commensurately, and thereby shortening the moving distance of the electrons and holes excited in the substrate to further enhance the photoelectric conversion efficiency and avoiding peeling issues of the finger electrodes to increase production capacity and yield. In addition, by utilizing the solar cells of the present invention, a solar cell string or a solar cell module may be easily obtained by connecting the solar cell units in series through wire bonding or ribbon bonding.

While the invention has been described in terms of what is presently considered to be the most practical and preferred embodiments, it is to be understood that the invention needs not be limited to the disclosed embodiment. On the contrary, it is intended to cover various modifications and similar arrangements included within the spirit and scope of the appended claims which are to be accorded with the broadest interpretation so as to encompass all such modifications and similar structures.

## Claims

1. A back contact solar cell, **characterized in that** the back contact solar cell comprises:
a main body, including at least one N-type doped region and at least one P-type doped region and having a light receiving surface and a back surface opposite to the light receiving surface;
at least one first main busbar electrode, at least one second main busbar electrode, a plurality of first finger electrodes and a plurality of second finger electrodes, all being disposed on the back surface and extending along a first direction, wherein the first finger electrodes and the second finger electrodes are electrically connected to the at least one N-type doped region and the at least one P-type doped region, respectively, and the first finger electrodes and the second finger electrodes are parallel and arranged alternately; and
at least one first sub-busbar electrode and at least one second sub-busbar electrode, disposed on the back surface and extending along a second direction different from the first direction, wherein the first sub-busbar electrode is electrically connected to the first main busbar electrode and the first finger electrodes, and the second sub-busbar electrode is electrically connected to the second main busbar electrode and the second finger electrodes.

2. The back contact solar cell according to claim 1, **characterized in that** an angle between the first direction and the second direction ranges from 45 degrees to 90 degrees.

3. The back contact solar cell according to claim 1, **characterized in that** each of the second finger electrodes has two branches electrically connected to the P-type doped region.

4. The back contact solar cell according to claim 3, **characterized in that** a width of the branches of the second finger electrodes is less than or equal to a width of the first finger electrode.

5. The back contact solar cell according to claim 1, **characterized in that** the main body comprises:
a plurality of the P-type doped regions of a strip shape; and
a plurality of the N-type doped regions of a strip shape,
the P-type doped regions and the N-type doped regions being arranged alternately along the second direction, each of the second finger electrodes being electrically connected to a corresponding one of the P-type doped regions, and each of the first finger electrodes being electrically connected to a corresponding one of the N-type doped regions.

6. The back contact solar cell according to claim 5, **characterized in that** the P-type doped regions are connected to the N-type doped regions.

7. The back contact solar cell according to claim 5, **characterized in that** the P-type doped regions are separated from the N-type doped regions by a dielectric layer.

8. The back contact solar cell according to claim 1, **characterized in that** the main body includes a plurality of the N-type doped regions surrounded by the P-type doped region.

9. The back contact solar cell according to claim 1, **characterized in that** a width of the second finger electrode is greater than or equal to a width of the first finger electrode.

10. The back contact solar cell according to claim 1, **characterized in that** a width of the first sub-busbar electrode is less than a width of the first main busbar electrode and greater than a width of the first finger electrodes; and a width of the second sub-busbar electrode is less than a width of the second main busbar electrode and greater than a width of the second finger electrodes.

11. A solar cell string comprising a plurality of the back contact solar cells according to claim 1, **characterized in that** the back contact solar cells are connected in series.

12. The solar cell string according to claim 11, **characterized in that** the second main busbar electrode of one of the back contact solar cells is electrically connected to the first main busbar electrode of a previous one of the back contact solar cells; and the first main busbar electrode of the one back contact solar cell is electrically connected to the second main busbar electrode of a next one of the back contact solar cells.

13. The solar cell string according to claim 12, **characterized in that** the second main busbar electrode of the one back contact solar cell is electrically connected to the first main busbar electrode of the previous back contact solar cell by wire bonding or ribbon bonding, and the first main busbar electrode of the one back contact solar cell is electrically connected to the second main busbar electrode of the next back contact solar cell by wire bonding or ribbon bonding.
